## Europäisches Patentamt

(19) **European Patent Office**

**Office européen des brevets**

(11) Publication number: **0 197 396 B1**

---

(12) **EUROPEAN PATENT SPECIFICATION**

(45) Date of publication of the patent specification:
01.08.90

(21) Application number: **86103901.4**

(22) Date of filing: **21.03.86**

(51) Int. Cl.⁵: **G03F 3/10**

---

⑤ Process for preparing a multicolour image.

---

(30) Priority: **05.04.85 US 720468**

(43) Date of publication of application:
**15.10.86 Bulletin 86/42**

(45) Publication of the grant of the patent:
**01.08.90 Bulletin 90/31**

(84) Designated Contracting States:
**DE FR GB**

(56) References cited:
**EP-A- 0 115 899**
**EP-A- 0 165 031**
**EP-A- 0 182 031**
**FR-A- 2 137 799**
**FR-A- 2 345 746**
**US-A- 3 671 236**
**US-A- 4 489 153**

(73) Proprietor: **HOECHST CELANESE CORPORATION,
Route 202-206 North, Somerville, N.J. 08876(US)**

(72) Inventor: **Barton, Oliver Alfred, 49 Afton Drive, Florham
Park New Jersey 07932(US)**
Inventor: **Wright, James D., 411 R.D. No. 5, Flemington
New Jersey 08822(US)**

(74) Representative: **Euler, Kurt Emil, Dr. et al, KALLE
Niederlassung der Hoechst AG
Rheingaustrasse 190 Postfach 3540,
D-6200 Wiesbaden 1(DE)**

---

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

ACTORUM AG

**Beschreibung**

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Druckbildes sein und soll den Tonwert der Farben weder erhöht noch herabgesetzt wiedergeben. Die visuelle Farbprüfung soll folgendes aufzeigen:

1. Fehler im Negativ,
2. die beste Farbwiedergabe, die beim Drucken in der Druckmaschine von dem Material zu erwarten ist,
3. die genaue Gradation aller Farbtöne und ob die Grautöne neutral sind,
4. die eventuelle Notwendigkeit zur Abschwächung einer der Farben und/oder Hinweise zur Änderung der Filmvorlagen vor der Herstellung der Druckplatten.

Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb alternative Farbprüfverfahren entwickelt, die den Andrucken in der Qualität gleichkommen sollen. Zwei photographische Farbprüfverfahren sind bekannt, nämlich das sogenannte Surprint-Verfahren (Übereinanderkopieren) und das sogenannte Overlay-Verfahren (Übereinanderlegen).

Beim Farbprüfen nach dem Overlay-Verfahren wird auf jeweils einem transparenten Kunststoffträger von jedem Farbauszug für sich ein Teilfarbenbild hergestellt. Zur Herstellung eines Farbprüfsatzes werden dann mehrere solcher mit Teilfarbenbildern versehener Träger übereinander auf ein weißes Blatt gelegt. Das Overlay-Verfahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von den Drucken unterscheidet, die man mit einem konventionellen Farbandruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturmaßnahmen dienen kann.

Bei der Prüfung nach dem Surprint-Verfahren wird ein Farbprüfbild angefertigt, indem nacheinander Bilder in verschiedenen Farben von verschiedenen Farbauszügen auf einem einzigen Empfangsblatt hergestellt werden. Dazu wird ein undurchsichtiger Träger verwendet, auf den nacheinander Toner oder lichtempfindliche Schichten in den entsprechenden Farben aufgebracht werden, wie es z.B. in den US-A 3 671 236 und 3 136 637 beschrieben ist. Das Surprint-Verfahren hat den Vorteil, daß die Farbwiedergabe nicht durch übereinanderliegende Kunststoffträger beeinflußt wird. Dieses Verfahren kommt dem tatsächlichen Druck näher und vermeidet die dem Overlay-Verfahren eigene Farbverfälschung.

Die US-A 3 574 049 beschreibt ein Übertragungsverfahren, bei dem ein Bild auf einem endgültigen Träger erzeugt wird. Dabei wird a) das Bild zunächst auf einen Zwischenträger übertragen, b) Zwischenträger und endgültiger Träger werden aufeinandergelegt, c) die aufeinanderliegenden Träger werden mit Wärme und/oder Druck beaufschlagt, und d) der Zwischenträger wird von dem endgültigen Träger getrennt, wobei das Bild auf dem endgültigen Träger zurückbleibt, da die bildformende Substanz eine größere Haftung zu diesem als zu dem Zwischenträger hat.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

In der EP-A 115 899 werden positiv arbeitende lichtempfindliche Farbprüffolien beschrieben, die auf einem transparenten Schichtträger eine Trennschicht, eine positiv arbeitende lichtempfindliche Farbschicht und eine Haftschicht tragen. Die Schichten werden auf ein Bildempfangsmaterial übertragen und dort belichtet und entwickelt. Auf diese Weise werden vier getrennte Teilfarben-Prüfbilder erzeugt; ein gemeinsames Mehrfarbenbild wird dabei nicht erhalten.

Aus der FR-A 2 137 799 ist es weiterhin bekannt, ein Schichtübertragungsmaterial aus einer Trägerfolie, einer wasserlöslichen, nicht thermoplastischen Zwischenschicht, einer photopolymerisierbaren Schicht und ggf. einer Deckfolie zur Herstellung von Farbprüfbildern einzusetzen, wenn die photopolymerisierbare Schicht in einer der Grundfarben eingefärbt ist. Hierbei wird auf einem Empfangsmaterial durch Übertragen der lichtempfindlichen Schicht, Belichten und Entwickeln ein Teilfarbenbild erzeugt, auf dem in gleicher Weise weitere Teilfarbenbilder durch Belichten von Schichten anderer Grundfarben im Register erzeugt werden. Die Übertragung der Schichten erfolgt unter Druck und Erwärmen, wobei die Haftung allein durch die Thermoplastizität der photopolymerisierbaren Schichten erreicht wird. Dabei besteht aber eine Neigung, daß Bildelemente eines Teilfarbenbilds durch das Laminieren der nächsten Bildschicht erweichen und verzerrt werden.

In der nicht vorveröffentlichten EP-A 182 031 (Anmeldenummer 85 11 1801.8, eingereicht am 18.9.1985) wird ein Verfahren zur Herstellung eines Mehrfarbenbildes durch Übertragen beschrieben, bei dem eine lichtempfindliche Schicht, die ein Diazoniumsalz-Polykondensationsprodukt und einen Farbstoff oder ein Pigment enthält und mit einer Haftschicht bedeckt ist, auf ein Bildempfangsmaterial übertragen, vor oder nach dem Übertragen belichtet und nach dem Übertragen entwickelt wird. Diese Schritte werden für alle Teilfarbenbilder wiederholt.

Aufgabe der Erfindung ist es, ein Verfahren zur Herstellung eines Mehrfarbenbildes vorzuschlagen, bei dem bei der Bildübertragung keine zusätzlichen Schichten aufgebracht und getrocknet werden müssen und das es erlaubt, mit dem gleichen lichtempfindlichen Material und der gleichen Vorlage entweder Teilfarbenbilder direkt auf einem Bildempfangsmaterial zu erzeugen oder zuvor einzeln zu prüfen und dann mit den übrigen Teilfarbenbildern auf dem Bildempfangsmaterial zu vereinigen.

Erfindungsgemäß wird ein Verfahren zur Herstellung eines Mehrfarbenbildes vorgeschlagen, bei dem man entweder

a) ein lichtempfindliches Material, das auf einem Schichtträger eine Trennschicht, eine photopolymerisierbare Schicht, die ein polymeres Bindemittel, eine polymerisierbare Verbindung mit mindestens zwei Acryl- oder Methacrylsäureestergruppen, einen Initiator, der bei Bestrahlung mit aktinischer Strahlung die radikalische Polymerisation der polymerisierbaren Verbindung einzuleiten vermag, und einen Farbstoff oder ein Farbpigment in einer der Grundfarben des Mehrfarbendrucks enthält, und eine Haftschicht in der angegebenen Reihenfolge trägt, wobei die Trennschicht an dem Schichtträger weniger haftet als an der photopolymerisierbaren Schicht, mit der Haftschicht auf ein Bildempfangsmaterial laminiert, den Schichtträger abzieht, die photopolymerisierbare Schicht bildmäßig unter einem Farbauszug belichtet, die Trennschicht und die unbelichteten Bereiche der photopolymerisierbaren Schicht mit einer Entwicklerlösung zu einem Teilfarbenbild auswäscht und das erhaltene Teilfarbenbild deckungsgleich auf dem Bildempfangsmaterial mit mindestens einem weiteren in gleicher Weise erzeugten Teilfarbenbild einer anderen Grundfarbe vereinigt oder

b) das lichtempfindliche Material belichtet, mit der Haftschicht auf ein Zwischenträgerblatt laminiert, den Schichtträger abzieht, die Trennschicht und die unbelichteten Bereiche der photopolymerisierbaren Schicht auswäscht, das erhaltene Teilfarbenbild zusammen mit der Haftschicht auf ein Bildempfangsmaterial laminiert, das Zwischenträgerblatt abzieht und die vorstehenden Verfahrensschritte mindestens einmal mit einem Material wiederholt, das ein anderes Teilfarbenbild liefert.

Für das herkömmliche Farbprüfbild werden vier Teilfarbenbilder in den Farben Blaugrün, Purpur, Gelb und Schwarz angefertigt. Wenn diese Bilder dann übereinander angeordnet werden, erscheint das simulierte Mehrfarbenbild. Wie vorstehend beschrieben, stellt man bei dem erfindungsgemäßen Verfahren zunächst ein lichtempfindliches Material her, das sich aus einem Träger mit drei übereinander aufgebrachten Schichten, nämlich einer Trennschicht, einer gefärbten, lichthärtbaren Schicht und einer Klebeschicht, zusammensetzt. Das Außergewöhnliche bei diesem Verfahren ist, daß man mit ein und demselben mehrschichtigen, lichtempfindlichen Material zwischen zwei Methoden zur Bilderzeugung wählen kann, und zwar zwischen der Übertragung ganzer gefärbter Schichten mit nachfolgender Bilderzeugung und der Herstellung einzelner Teilfarbenbilder, wobei dann nur die Bilder auf dem endgültigen Träger übereinander übertragen werden.

1. Wenn die vollständige, gefärbte, lichtempfindliche Schicht übertragen werden soll, wird ein mehrschichtiges Material in einer ersten Farbe auf den endgültigen Träger übertragen, dann bildmäßig belichtet und entwickelt. Bei diesem Verfahren handelt es sich um ein schrittweises Farbübertragungsverfahren, und jede folgende Schicht muß auf das vorhergehende Farbbild übertragen, passergenau belichtet und entwickelt werden, damit man das komplette Vierfarbenprüfbild erhält.

2. Wenn das Bild übertragen werden soll, wird das mehrschichtige Material im Kontakt belichtet. Die Schicht mit dem latenten Bild wird dann auf einen Zwischenträger, vorzugsweise eine Polyesterfolie, übertragen, bevor das Bild mit der Entwicklerlösung entwickelt wird. Bei der Vierfarbenübertragung wird jede Farbschicht auf die gleiche Weise belichtet, auf ihre eigene Polyesterfolie übertragen und dann zum Bild entwickelt. In einem letzten Schritt werden die Bilder passergenau auf einen gemeinsamen Schichtträger übertragen, so daß man ein seitenrichtiges Bild erhält.

Das Bildübertragungsverfahren erlaubt die visuelle Prüfung der einzelnen Bilder vor der Übertragung auf einen endgültigen Träger, so daß fehlerhafte Bilder ausgetauscht werden können. Das Schichtübertragungsverfahren dagegen ergibt sofort das seitenrichtige Bild.

In der bevorzugten Ausführung können Schichtträger, Bildempfangsmaterial und Zwischenträger aus jedem geeigneten flexiblen, blattförmigen Material bestehen, das vorzugsweise transparent ist. Ferner soll das Material vorzugsweise maßbeständig sein und den hier beschriebenen Verarbeitungsverfahren standhalten, d.h., es sollte im wesentlichen unempfindlich gegen die Entwicklerlösungen sein, und beim Erwärmen auf Temperaturen im Bereich von etwa 60 bis 70 °C sollten im wesentlichen keine Veränderungen in den Abmessungen auftreten. Beispiele für geeignete blattförmige Materialien sind die folgenden: Glas, Metall, z.B. Aluminiumplatten, Papier, Silizium und Folien aus Acrylnitril/Butadien/Styrol-Terpolymeren (ABS), Celluloseacetat, Cellulosepropionat, Polybuten, Polybutadien, Polycarbonat, Polyestern, Polyethersulfon, Polyethylen niedriger, mittlerer und hoher Dichte, Ethylen/Propylen-Copolymeren, Ethylen/Vinylacetat-Copolymeren, Polyamiden, Acrylnitrilcopolymeren, Ionomeren, Polyimiden, Polymethylmethacrylaten, Polychlortrifluorethylenen, fluorierten Ethylen/Propylen-Copolymeren, Perfluoralkoxyharzen, Ethylen/Chlortrifluorethylen-Copolymeren, Ethylen/Tetrafluorethylen-Copolymeren, Polyvinylfluoridharzen, Polyvinylidenfluoridharzen, Polypropylenen, Polystyrol (und orientiertem Polystyrol), Polyurethanelastomeren, PVC weich, PVC hart, Harzen aus PVC-Copolymeren, Polyvinylidenchlorid und dessen Copolymeren, Polyvinylacetat und Polyvinylalkohol, sowie Kombinationen dieser Materialien.

Für diese blattförmigen Materialien wird transparentes Polyethylenterephthalat mit einer Dicke von etwa 75 μm besonders bevorzugt.

Als erste Schicht wird die Trennschicht auf den Träger aufgebracht. Durch die Trennschicht soll sich der gesamte Schichtverbund beim Übertragen auf den permanenten Träger und/oder den Zwischenträger leicht von Träger ablösen lassen.

Die bevorzugten Trennschichten werden in Form einer wäßrigen Lösung aus einem wasserlöslichen Polymeren auf den Träger aufgebracht und anschließend die Lösemittel aus der Beschichtung vertrieben. Bevorzugte wasserlösliche Polymere sind z.B. Polyvinylalkohol, Polyvinylpyrrolidon, Hydroxypropylcellulose, Methylcellulose, Ethylcellulose, Hydroxyethylcellulose, Ethylhydroxyethylcellulose, Gelatine, Gummi arabicum und Polyvinylether/Maleinsäureanhydrid-Copolymere. Als Lösemittel können z.B. Wasser und Alkohole verwendet werden. Wenn die Trennschicht nicht wasserlöslich ist, sollte sie jedenfalls in dem zur Verarbeitung der photopolymerisierbaren Schicht verwendeten Entwickler löslich sein.

Die Trennschicht soll bewirken, daß sich die später aufgebrachten Schichten glatt, d.h. ohne zu kleben oder sich zu verschieben, vom Träger lösen, und sie soll stärker an den später aufgebrachten Schichten als am Träger haften.

Dieses Ergebnis ist im allgemeinen dadurch zu erreichen, daß man für die Trennschicht Substanzen mit relativ geringen Oberflächenenergien einsetzt, die jedoch noch ausreichend an der gefärbten photopolymerisierbaren Schicht haften. Ferner muß die Schicht in den zum Auftragen der lichtempfindlichen Schicht verwendeten Lösemitteln unlöslich sein. Die Trennschicht hat nur dann die gewünschte Wirkung, wenn sich die Bindung zwischen Trennschicht und Träger beim Übertragungsvorgang löst. Modifizierende Zusätze zur Trennschicht, mit denen das Haftvermögen der Trennschicht an der gefärbten Schicht eingestellt wird, sind normalerweise wasserlösliche Polymere, die stärker hydrophob sind als das die Trennwirkung aufweisende Polymere selbst. Solche modifizierenden Zusätze lassen sich in einfacher Weise experimentell ermitteln.

In der bevorzugten Ausführung enthält die Trennschicht sowohl Polyvinylalkohol als auch Polyvinylpyrrolidon. In der trockenen Schicht ist vorzugsweise Polyvinylalkohol in einem Anteil von etwa 69 bis 88 Gew.-%, Polyvinylpyrrolidon in einem Anteil von etwa 22 bis 39 Gew.-% enthalten. Dabei werden als Polyvinylalkohol z.B. Gelva 20/30 von der Firma Monsanto und als Polyvinylpyrrolidone die Marken K-60 und K-30 von der Firma G.A.F. eingesetzt.

Eine bevorzugte Beschichtungslösung zur Herstellung der Trennschicht hat z.B. die folgende Zusammensetzung

| | Gew.-% | | |
|---|---|---|---|
| Polyvinylalkohol Gelva 20/30 | 3,2 | ± | 0,5 |
| Polyvinylpyrrolidon K-60 MG 160.000, 45%ige wäßrige Lösung | 0,9 | ± | 0,2 |
| Polyvinylpyrrolidon K-30 MG 40.000 | 0,52 | ± | 0,15 |
| Ethanol | 20,1 | ± | 5,0 |
| Wasser | 75,3 | ± | 5,0 |

Als nächste Schicht wird die gefärbte, lichtempfindliche Schicht vorzugsweise aus einer in organischem Lösemittel gelösten Beschichtungslösung aufgebracht. Diese Beschichtungslösung kann auf die wasserlösliche Trennschicht aufgetragen werden, ohne ein Anlösen der Trennschicht befürchten zu müssen. Für die gefärbte, lichtempfindliche Schicht werden wegen des unterschiedlichen Löslichkeitsverhaltens ihrer Bestandteile organische Lösemittel bevorzugt.

Eine typische lichtempfindliche Schicht enthält ein polymerisierbares Monomeres, einen Photoinitiator, ein Bindemittel, Farbmittel, d.h. Farbstoffe oder Pigmente, und gegebenenfalls Füllstoffe.

Die in der gefärbten, lichtempfindlichen Schicht enthaltene polymerisierbare Substanz besteht aus einer ungesättigten Verbindung mit einer Siedetemperatur oberhalb 100 °C bei Normaldruck und mindestens zwei ethylenischen Endgruppen, die befähigt ist, durch radikalisch initiierte Additionskettenpolymerisation ein hochmolekulares Polymeres zu bilden. Als polymerisierbare Substanzen sind z.B. geeignet: Polybutandioldiacrylat, Tetraethylenglykoldimethacrylat, Ethylenglykoldimethacrylat, Trimethylolpropantrimethacrylat, Trimethylolpropantriacrylat, Propylenglykol-200-diacrylat, Diethylenglykoldimethacrylat, Pentaerythrittetraacrylat, 1,4-Butandioldiacrylat, 1,6-Hexandioldimethacrylat, Dipentaerythritpentaacrylat, ethoxyliertes Bisphenol-A-dimethacrylat und Tripropylenglykoldiacrylat.

Zu den radikalbildenden Photoinitiatoren zählen alle Verbindungen, die nach Anregung durch aktinische Strahlung Radikale bilden. Beispiele für bevorzugte Photoinitiatoren sind 2,3-Di-(p-Methoxyphenyl)chinoxalin, 9-Phenylacridin, die in der US-A 2 367 660 beschriebenen vicinalen Polyketaldonylverbindungen, die in den US-A 2 367 661 und 2 367 670 beschriebenen $\alpha$-Carbonylverbindungen, die Acyloinether aus der US-A 2 448 828, die Triarylimidazolyldimer/Aminophenylketon-Kombinationen aus der US-A 3 549 367 sowie die in den US-A 3 640 718 und 3 617 288 beschriebenen farbstoffsensibilisierten photolysierbaren organischen Halogenverbindungen.

Die Pigmente oder Farbstoffe zum Anfärben der Bildstellen sind normalerweise in den lichtempfindlichen Schichten enthalten.

Erfindungsgemäß werden als Farbmittel Pigmente gegenüber Farbstoffen vorgezogen. Sie werden z.B. in einer Lösung von Poly-(Methylmethacrylat/Methacrylsäure) in Butanon dispergiert. Die Pigmentpartikel werden so fein gemahlen, daß sie in Partikelgröße und Farbton mit entsprechenden Druckfarben vergleichbar sind.

Die folgenden Pigmentdispersionen werden bevorzugt:

EP 0 197 396 B1

| Bestandteil | Blaugrün Gew.-% | Purpur-Blau Gew.-% | Purpur-Rot Gew.-% | Chinacridonrot Gew.-% | Gelb Gew.-% | Schwarz Gew.-% |
|---|---|---|---|---|---|---|
| Phthalocyaninblau CI 74160 | 10,0 | | | | | |
| Rhodaminrot CI 45160 | | 7,0 | | | | |
| Chinacridonrot CI 46500 | | | | 7,0 | | |
| "Bon Red Yellow Shade" CI 15865/1 | | | 7,0 | | | |
| Diarylidgelb (American Hoechst Corp.) | | | | | 5,0 | |
| Ofenruß CI 77266 | | | | | | 4,5 |
| Poly(methylmethacrylat/ methacrylsäure) 85/15 | 26,3 | 26,3 | 26,3 | 26,3 | 26,3 | 28,1 |
| Butanon | 63,7 | 66,7 | 66,7 | 66,7 | 68,7 | 67,5 |

Weitere Beispiele für erfindungsgemäß verwendbare Farbmittel sind: Benzidingelb (C.I. 21.090), Benzidingelb GR (C.I. 21.100), Permanentgelb DHG (Hersteller Hoechst AG), Brillantkarmin 6B (C.I. 15.850), Rhodamin 6G (C.I. 45.160, Rhodamin B (C.I. 45.170), Phthalocyaninblau, nichtkristallin (C.I. 74.160), Phthalocyaningrün (C.I. 74.260), Ruß, Fettgelb 5G, Fettgelb 3G, Fettrot G, Fettrot HRR, Fettrot 5B, Fettschwarz HB, Zaponechtschwarz RE, Zaponechtschwarz B, Zaponechtblau HFL, Zaponechtrot BB, Zaponechtrot GE, Zaponechtgelb und Chinacridonrot (C.I. 46.500).

Die lichtempfindliche Schicht enthält ferner ein Bindemittel, das nicht nur die Härte und/oder Flexibilität der Schicht bestimmt, sondern auch zur Steuerung der Bildentwicklung dient. Wenn beispielsweise das Bindemittel in dem verwendeten Entwickler zu stark löslich ist und zu wenig polymerisierbares Monomeres da ist, wird das Bild ausgewaschen. Ist dagegen zu wenig Bindemittel und zu viel polymerisierbares Monomeres anwesend, ist die Schicht vor dem Belichten weich und fließfähig, oder die belichteten Bildstellen können zu hart sein, um sich gut übertragen zu lassen.

6

Als Bindemittel sind z.B. geeignet: Styrol/Maleinsäureanhydrid-Copolymere (etwa 40:60 bis 70:30), Methylmethacrylat/Methacrylsäure-Copolymere (etwa 70:30 bis 95:5), Methylmethacrylat/Ethylacrylat/Methacrylsäure-Terpolymere (etwa 50:30:20 bis 90:5:5) und Methylmethacrylat/Butylacrylat/-Methacrylsäure-Terpolymere (etwa 50:30:20 bis 90:5:5). Es können auch Bindemittel verwendet werden, deren Säurezahl 0 beträgt, deren Löslichkeitsverhalten jedoch so ist, daß sie sich beim Entwickeln mit den bevorzugten wäßrig-alkalischen Entwicklern gut lösen. Solche Bindemittel sind z.B. die Polyvinylpyrrolidone K-60 und K-90 (G.A.F.), Hydroxypropylcellulose, Methylcellulose und Ethylhydroxyethylcellulose.

Der Anteil an photopolymerisierbaren Monomeren in der lichtempfindlichen Schicht beträgt erfindungsgemäß etwa 18 bis 50 Gew.-%, vorzugsweise etwa 20 bis 45 Gew.-% und insbesondere etwa 25 bis 45 Gew.-%, bezogen auf die nichtflüchtigen Bestandteile der Schicht.

Der Anteil an Photoinitiator in der lichtempfindlichen Schicht beträgt erfindungsgemäß etwa 2 bis 15 Gew.-%, vorzugsweise etwa 3 bis 12 Gew.-% und insbesondere etwa 3,5 bis 12 Gew.-%, bezogen auf die nichtflüchtigen Bestandteile der Schicht.

Der Farbmittelanteil in der lichtempfindlichen Schicht beträgt erfindungsgemäß etwa 0,05 bis 15 Gew.-%, vorzugsweise etwa 1 bis 12 Gew.-% und insbesondere etwa 2 bis 10 Gew.-%, bezogen auf die nichtflüchtigen Bestandteile der Schicht.

Der Bindemittelanteil in der lichtempfindlichen Schicht beträgt erfindungsgemäß etwa 20 bis 70 Gew.-%, vorzugsweise etwa 20 bis 60 Gew.-% und insbesondere etwa 30 bis 55 Gew.-%, bezogen auf die nichtflüchtigen Bestandteile der Schicht.

Die Bestandteile der lichtempfindlichen Schicht werden in einem geeigneten Lösemittelgemisch gelöst bzw. dispergiert, die Lösung oder Dispersion wird auf den Träger aufgebracht und die Lösemittel durch Trocknen vertrieben. Als Lösemittel können z.B. Butanon, 2-Methoxy-ethanol und Butyrolacton verwendet werden. Die lichtempfindliche Schicht kann gegebenenfalls noch Tenside und inerte Füllstoffe enthalten.

Für die lichtempfindlichen Schichten werden z.B. die folgenden Zusammensetzungen bevorzugt:

| Komponente | Blau-grün | Purpur | Gelb | Schwarz |
|---|---|---|---|---|
| | | (Gewichtsprozent) | | |
| blaugrüne Dispersion | 8,95 | | | |
| gelbe Dispersion | | | 24,53 | |
| Purpur-Blau-Dispersion | | 8,28 | | |
| Purpur-Rot-Dispersion | | 8,28 | | |
| schwarze Dispersion | | | | 18,15 |
| Butanon | 37,10 | 32,29 | 28,90 | 31,45 |
| 2-Methoxy-ethanol | 37,10 | 32,29 | 28,90 | 31,45 |
| Butyrolacton | 3,87 | 7,82 | 7,73 | 7,29 |
| Methylmethacrylat/ Methacrylsäure- Copolymere (85:15) | 2,88 | 0,94 | | 2,19 |
| Methylmethacrylat/ Methacrylsäure- Copolymeres (95: 5) | 3,71 | 3,26 | 3,37 | 3,14 |
| Polybutandiol- diacrylat | 4,15 | 4,56 | 4,33 | 4,23 |
| Byk 301* (1,5%ige Lösung in 2-Methoxy-ethanol | 0,64 | 0,65 | 0,64 | 0,60 |
| 2,3-Di-(p-Methoxy- phenyl)chinoxalin | 0,96 | 0,98 | 0,96 | 0,90 |
| 9-Phenylacridin | 0,64 | 0,65 | 0,64 | 0,60 |

*Polyglykol-Siloxan-Tensid, Hersteller Byk/Mallinckrodt, Melville, New York

Als nächstes wird die Haftschicht auf die lichtempfindliche Schicht aufgebracht. Sie soll bei der Übertragung des Schichtverbunds helfen und bereits entwickelte Teilfarbenbilder gegen eine spätere Überentwicklung schützen. Deshalb wird vorzugsweise ein in Wasser dispergierbares Harz verwendet, das beim Auftragen als Dispersion die Komponenten der lichtempfindlichen Schicht nicht anlöst und andererseits in trockenem Zustand nicht von dem alkalischen Entwickler aufgelöst wird.

Polyvinylacetat wird hierbei bevorzugt. Die Haftschicht wird durch Wärme aktiviert, und bei dem hier beschriebenen Laminierübertragungsverfahren wird vorzugsweise ein Harz mit einer Aktivierungstemperatur verwendet, die weit genug unterhalb der Temperatur liegt, bei der das Trägermaterial schrumpft.

In einer weiteren bevorzugten Ausführung enthält die Haftschicht ferner einen Weichmacher. Geeignete Weichmacher sind Phthalate, wie Dibutylphthalat, Butylbenzylphthalat und Dimethylphthalat. Andere brauchbare Weichmacher lassen sich leicht herausfinden. Das für das erfindungsgemäße Verfahren geeignete Haftmittel hat z.B. folgende Zusammensetzung:

| Komponente | Beschichtungs-masse | trockene Schicht |
|---|---|---|
| | Gew.-% | Gew.-% |
| Polyvinylacetat-dispersion Gelva TS-85 (Monsanto) 55 % Feststoffanteil | 31,38 | 60,24 ± 5,0 |
| Polyvinylacetat-dispersion Mowilith DM-22 (American Hoechst) 55 % Feststoffanteil | 20,20 | 38,77 ± 5,0 |
| Butylbenzylphthalat | 0,51 | 1,0 ± 0,2 |
| Wasser | 47,91 | |

Außerdem können noch wäßrige Dispersionen der folgenden Polymeren eingesetzt werden: von Acrylpolymeren, -copolymeren oder terpolymeren, von Vinylcopolymeren und -terpolymeren und von anderen Vinylacetatcopolymeren und -terpolymeren oder von weiteren Varianten dieser Polymeren, die eine Erweichungstemperatur von etwa 65 bis 82 °C haben.

Mit dem lichtempfindlichen Material kann wahlweise nach einem von zwei Verfahren ein Farbprüfbild hergestellt werden.

Bei dem einen Verfahren wird das lichtempfindliche Material mit der Haftschicht auf ein Bildempfangsmaterial laminiert. Dabei werden zunächst die Haftschicht, die lichtempfindliche Schicht und die Trennschicht auf das Empfangsmaterial übertragen, und dann wird der Schichtträger gewöhnlich von Hand abgezogen. Anschließend wird die lichtempfindliche Schicht mit aktinischer Strahlung bildmäßig belichtet, und die Trennschicht und die unbelichteten Bereiche der gefärbten, lichtempfindlichen Schicht werden mit einem flüssigen Entwickler ausgewaschen, so daß ein farbiges Bild auf dem Empfangsmaterial zurückbleibt. Jeder dieser Schritte wird dann jeweils einmal mit mindestens einer anderen Farbe wiederholt, wobei das nächste farbige Bild über dem ersten farbigen Bild auf der gleichen Seite des Empfangsmaterials hergestellt wird.

Bei dem zweiten Verfahren wird eine farbige, lichtempfindliche Schicht zunächst mit aktinischer Strahlung bildmäßig belichtet. Anschließend wird das belichtete Material auf einen Zwischenträger laminiert. Der Schichtträger wird abgezogen, und dann werden im wesentlichen die gesamte Trennschicht und die unbelichteten Bereiche der gefärbten, lichtempfindlichen Schicht mit einer Entwicklerflüssigkeit entfernt, so daß ein farbiges Bild auf Haftschicht und Zwischenträger zurückbleibt. Dieses Bild wird dann zusammen mit der Haftschicht auf ein Empfangsmaterial laminiert und der Zwischenträger abgezogen. Jeder dieser Schritte wird mit mindestens einer anderen Farbe wiederholt, wobei jedes weitere Farbbild auf dieselbe Seite des Empfangsmaterials laminiert wird.

Das Laminieren kann so durchgeführt werden, daß das Empfangsmaterial mit der beschichteten Seite des gefärbten, lichtempfindlichen Materials in Kontakt gebracht wird und dann beide Materialien unter entsprechendem Druck durch den Walzenspalt eines beheizten Laminierwalzenpaares hindurchgeführt werden. Die Temperatur beim Laminieren liegt gewöhnlich im Bereich von etwa 60 bis 90 °C, vorzugsweise bei etwa 75 bis 85 °C. Nach dem Laminieren wird der Schichtträger bzw. der Zwischenträger normalerweise von Hand abgezogen.

Die lichtempfindliche Schicht wird in bekannter Weise entweder vor oder nach dem Laminieren z.B. im Vakuumkopierrahmen mit UV-Licht durch eine übliche Negativvorlage bildmäßig belichtet. Quecksilber-

dampflampen werden gegenüber Metallhalogenidlampen bevorzugt. Es können auch Filter eingesetzt werden, um die Lichtstreuung im Material zu reduzieren.

Nach dem Belichten wird die lichtempfindliche Schicht durch Auswaschen der nichtbelichteten Bereiche mit einer geeigneten Entwicklerflüssigkeit entwickelt und dann getrocknet. Durch diese Entwicklung wird die Haftschicht nicht entfernt. Ein geeigneter Entwickler hat z.B. die folgende Zusammensetzung:

Wasser 88,5%
Mononatriumphosphat 0,5%
Trinatriumphosphat 2,5%
Natriumsalz von 7-Ethyl-2-methyl-4-undecylsulfat 8,5%

Es kann jedoch jede beliebige Entwicklerlösung verwendet werden, die die nichtbelichteten Bereiche der lichtempfindlichen Schicht nach der Belichtung einwandfrei entfernt und die Bildstellen nicht angreift. Der bevorzugte Entwickler ist eine wäßrig-alkalische Lösung.

Normalerweise werden vier gefärbte Schichten verwendet, um ein gewünschtes Bild in allen Farben wiederzugeben. Diese Schichten haben die Farben Blaugrün, Purpur, Gelb und Schwarz.

Die folgenden Beispiele sollen die Erfindung näher erläutern.

Beispiel 1

Zur Herstellung einer Trennschicht werden zunächst 1,5 kg Polyvinylalkohol (Gelvatol 20/30, Hersteller Monsanto) in 30 kg entsalztem Wasser gelöst und dann mit 15 kg Ethanol versetzt. Die erhaltene klare Lösung wird auf eine 75 mm dicke, transparente Polyesterfolie aufgebracht und 1 Minute bei 65 °C getrocknet, so daß sich ein Schichtgewicht von 0,87 g/m² ergibt.

Eine lichtempfindliche Beschichtungslösung wird aus den folgenden Komponenten unter mäßigem Rühren hergestellt:

5,1 kg eines Copolymeren aus Methylmethacrylat und Methyacrylsäure (85:15, Molekulargewicht 30.000) als 36%ige Lösung in Butanon,
1,5 kg Trimethylolpropantriacrylat,
0,075 kg Viktoriareinblau FGA
0,005 kg Calcozingelb SFW
0,15 kg 9-Phenylacridin,
9,00 kg Butanon und
9,00 kg 2-Methoxy-ethanol.

Die Lösung wird auf die getrocknete Trennschicht aufgebracht und bei 65 °C getrocknet, so daß sich ein Trockenschichtgewicht von 1,5 ± 0,5 g/m² ergibt.

Zur Herstellung einer Haftschicht werden 15 kg einer Polyvinylacetatdispersion (TS-85 von Monsanto; 55 % Feststoffgehalt) mit 3 kg entsalztem Wasser vermischt. Das Gemisch wird zu einem Beschichtungsgewicht von 5 g/m² auf die getrocknete lichtempfindliche Schicht aufgebracht.

Der blattförmige Verbund wird mittels eines Walzenlaminators auf eine mit einem Haftvermittler vorbehandelte Polyesterfolie übertragen.

Nach dem Laminieren wird der Schichtverbund abgekühlt und der Schichtträger abgezogen. Die Übertragung erfolgt hier, weil sich der Verbund an der Grenzfläche Trennschicht/Schichtträger auftrennt.

Die übertragene Schicht wird durch ein Negativ in einem Berkey-Ascor-Belichtungsgerät 40 Sekunden belichtet.

Das belichtete Material wird dann mit der beschichteten Seite nach oben in ein Entwicklungsbecken gelegt und mit einer reichlichen Menge einer wäßrig-alkalischen Entwicklerlösung übergossen, die man 20 Sekunden einwirken läßt. Zur Bildentwicklung wird das nasse Material mit einem weichen Wattebausch während 40 Sekunden leicht überrieben, wobei die unbelichteten Bereiche entfernt werden und das gewünschte Bild zurückbleibt.

Beispiel 2

Es wird wie in Beispiel 1 eine Trennschichtlösung aus 1 kg Gelvatol 20/60, 20 kg entsalztem Wasser und 10 kg Ethanol hergestellt und wie in Beispiel 1 durch Umkehrwalzenbeschichtung zu einem Beschichtungsgewicht von 0,85 g/m² auf eine Polyesterfolie aufgebracht.

Für die lichtempfindliche Schicht werden wie in Beispiel 1 die folgenden Komponenten unter mäßigem Rühren gelöst:

5,1 kg eines Copolymeren aus Methylmethacrylat und Methacrylsäure (85:15, Molekulargewicht 30.000) als 36%ige Lösung in Butanon,
1,5 kg Trimethylolpropantriacrylat,
0,002 kg Viktoriareinblau FGA,
0,110 kg Rhodamin 6 GDN,
0,075 kg Rhodamin FG,
0,035 kg Calcozingelb SFW,
0,170 kg 9-Phenylacridin,

9,00 kg Butanon,
9,00 kg 2-Methoxy-ethanol.

Die getrocknete Trennschicht wird wie in Beispiel 1 mit der lichtempfindlichen Lösung schleuderbeschichtet und die Schicht 1,5 Minuten bei 62 bis 69 °C getrocknet, so daß sich ein Trockenschichtgewicht von 1,3 g/m² ergibt.

Eine Haftschichtlösung wird unter mäßigem Rühren aus den folgenden Komponenten hergestellt:
1,6 kg Polyvinylacetat (Mowilith 25 - 55%ige wäßrige Dispersion),
25 kg Butanol und
6,2 kg entsalztes Wasser.

Diese Lösung wird durch Umkehrwalzenbeschichtung zu einem Beschichtungsgewicht von 4,5 g/m² auf die lichtempfindliche Schicht aufgetragen. Der Schichtverbund wird wie in Beispiel 1 als ganze, gefärbte Schicht übertragen, belichtet und entwickelt.

Weitere Primärfarbschichten können nacheinander auf diese blaugrüne Schicht übertragen werden und in gleicher Weise belichtet und entwickelt werden, so daß schließlich ein vierfarbiges Prüfbild entsteht.

Sollen dagegen Bilder anstelle von ganzen, gefärbten Schichten übertragen werden, kann der Schichtverbund (Haftschicht/lichtempfindliche Schicht/Trennschicht) belichtet und auf eine haftvermittelnd vorbehandelte Polyesterfolie übertragen (und der Schichtträger abgezogen) werden. Das Bild (seitenverkehrt) wird wie oben beschrieben entwickelt und kann auf Fehler geprüft werden, bevor es auf den endgültigen Träger passergenau übertragen wird (z.B. auf Papier, das für den tatsächlichen Auflagendruck verwendet werden soll). Auch der Zwischenträger wird nach der Bildübertragung wieder abgezogen.

Die Schichten in den übrigen Primärfarben werden belichtet, übertragen, entwickelt und auf Fehler geprüft und können dann auf die gleiche Weise nacheinander deckungsgleich (auf den endgültigen Träger) übertragen werden.

Beispiel 3

Zur Herstellung einer Trennschicht werden die folgenden Komponenten unter mäßigem Rühren gelöst:
1,41 kg Polyvinylalkohol (Gelvatol 20/30, Monsanto),
0,168 kg Polyvinylalkohol (Gelvatol 20/90, Monsanto),
33,75 kg entsalztes Wasser und
9,39 kg Ethanol.

Dabei wird vorzugsweise zunächst der Polyvinylalkohol im Wasser gelöst und dann das Ethanol zugegeben.

Zwei verschiedene purpurfarbene Stammdispersionen werden durch Vermahlen der folgenden Komponenten hergestellt:

| 1 | 2 | |
|---|---|---|
| | 0,700 kg | "Bon Red Yellow Shade" (C.I. 15.865/I) |
| 0,700 kg | | Rhodaminrot (C.I. 45.160) |
| 2,630 kg | 2,630 kg | eines Copolymeren aus Methylmethacrylat und Methacrylsäure (85:15) als 36%ige Lösung in Butanon, |
| 6,670 kg | 6,670 kg | Butanon. |

Von diesen Stammdispersionen werden gleiche Teile unter mäßigem Rühren, wie in Beispiel 1, zu folgendem lichtempfindlichen Gemisch gegeben:
1,27 kg Dispersion 2,
1,27 kg Dispersion 1,
0,145 kg eines Copolymeren aus Methylmethacrylat und Methacrylsäure (85:15, 100 % Feststoff, Hersteller Esschem),
0,50 kg eines Copolymeren aus Methylmethacrylat und Methacrylsäure (95: 5, 100 % Feststoff, Hersteller Esschem),
0,70 kg Polybutandioldiacrylat (Hersteller Alcolac),
0,10 kg Byk 301-Lösung (Silikonharz, 0,5%ige Lösung in 2-Methoxy-ethanol

0,10 kg 9-Phenylacridin,
4,95 kg 2-Methoxy-ethanol,
4,95 kg Butanon und
1,20 kg Butyrolacton.

Die lichtempfindliche Dispersion wird wie in Beispiel 1 mit Hilfe eines Dreiwalzen-Umkehrbeschichters auf die trockene Trennschicht aufgebracht und 1 Minute bei 65 °C getrocknet, so daß sich ein Trockenschichtgewicht von 1,5 g/m² ergibt.

Für die Haftschichtdispersion werden die folgenden Komponenten bei Umgebungstemperatur bis zur Herstellung einer homogenen Mischung gemischt:

7,3 kg Polyvinylacetatdispersion (TS-85; 55%ig, MG 30.000, Monsanto),
4,7 kg Polyvinylacetatdispersion (Mowilith DM-22; 55%ig; MG 20.000, Hoechst)
0,012 kg Butylbenzylphthalat und
11,25 kg entsalztes Wasser.

Die Lösung wird durch Umkehrwalzenbeschichtung zu einem Beschichtungsgewicht von 5,2 g/m² auf die lichtempfindliche Schicht aufgebracht.

Der Schichtverbund wird dann wie in Beispiel 1 mit einem Walzenlaminator auf eine haftvermittelnd vorbehandelte Polyesterfolie aufgebracht, belichtet und in einem Entwicklungsgerät bei 27 °C entwickelt.

Beispiel 4

Zur Herstellung einer Trennschicht werden die folgenden Komponenten unter mäßigem Rühren gelöst:
0,948 kg Gelvatol 20/30,
0,260 kg Polyvinylpyrrolidon K-60 (G.A.F.),
0,156 kg Polyvinylpyrrolidon K-30 (G.A.F.),
6,0 kg Ethanol und
22,5 kg entsalztes Wasser.

Die Lösung wird wie im Beispiel 1 mit einem Umkehrwalzenbeschichter zu einem Beschichtungsgewicht von 0,8g/m2 auf unbehandelte Polyesterfolie aufgebracht.

Eine gelbe Stammdispersionen wird durch Vermahlen der folgenden Komponenten hergestellt:
0,500 kg Diarylidgelb (American Hoechst Corporation),
2,530 kg eines Copolymeren aus Methylmethacrylat und Methacrylsäure (85:15) und
6,879 kg Butanon.

Diese Dispersion wird unter mäßigem Rühren der lichtempfindlichen Lösung zugesetzt, so daß man folgendes Gemisch enthält:
3,83 kg gelbe Dispersion,
0,525 kg eines Copolymeren aus Methylmethacrylat und Methacrylsäure (85:15),
0,60 kg Polybutandioldiacrylat,
0,15 kg 2,3-Di-(p-methoxyphenyl)chinoxalin,
0,10 kg 9-Phenylacridin,
4,50 kg Butanon,
1,20 kg Butyrolacton und
0,10 kg Byk 301 (0,5%ige Lösung in 2-Methoxy-ethanol).

Die lichtempfindliche Mischung wird wie in Beispiel 1 mit einem Dreiwalzen-Umkehrbeschichter auf die trockene Trennschicht aufgebracht und 1 Minute bei 65 °C getrocknet, so daß sich ein Trockenschichtgewicht von 1,43 g/m² ergibt.

Es wird eine Haftschichtdispersion gemäß Beispiel 1 hergestellt und mit einem Dreiwalzen-Umkehrbeschichter zu einem Beschichtungsgewicht von 4,5 g/m² auf die lichtempfindliche Schicht aufgebracht.

Der erhaltene Schichtverbund wird einmal zur Übertragung der kompletten Farbschicht und einmal zur Bildübertragung verwendet.

Beispiel 5

Zur Herstellung einer Trennschicht werden die folgenden Komponenten unter mäßigem Rühren gelöst:
1,4 kg Gelvatol 20/30,
0,168 kg Polyvinylpyrrolidon K-90 (G.A.F.),
9,39 kg Ethanol und
33,75 kg entsalztes Wasser.

Die Lösung wird wie im Beispiel 1 mit Hilfe eines Umkehrwalzenbeschichters zu einem Beschichtungsgewicht vom 0,85 g/m² auf unbehandelte Polyesterfolie aufgebracht.

Es wird eine schwarze Stammdispersionen durch Vermahlen der folgenden Komponenten hergestellt:
0,450 kg Ruß BK-6 (C.I. 77.266)
2,800 kg eines Copolymeren aus Methylmethacrylat und Methacrylsäure (85:15, MG 30.000) und
6,750 kg Butanon.

Mit einem Teil der Stammdispersionen wird das folgende lichtempfindliche Gemisch unter mäßigem Rühren vermischt:
0,0181 kg Rußdispersion
0,363 kg eines Copolymeren aus Methylmethacrylat und Methacrylsäure (85:15),
0,520 kg eines Copolymeren aus Methylmethacrylat und Methacrylsäure (95: 5) und
0,600 kg Polybutandioldiacrylat,
0,125 kg Byk 301 (0,5%ige Lösung in 2-Methoxy-ethanol),
0,125 kg 2,3-Di-(p-methoxyphenyl)chinoxalin,
0,05 kg 9-Phenylacridin,
5,20 kg 2-Methoxy-ethanol,
5,20 kg Butanon
1,20 kg Butyrolacton.

Die lichtempfindliche Dispersion wird wie in Beispiel 3 auf die trockene Trennschicht aufgebracht und 1 Minute bei 65 °C getrocknet, so daß sich ein Trockenschichtgewicht von 1,5 g/m$^2$ ergibt.

Es wird eine Haftschichtlösung hergestellt, indem die folgenden Komponenten bei Umgebungstemperatur homogen miteinander vermischt werden:
10,0 kg Polyvinylacetatemulsion (TS-85; 55%ig, Monsanto),
5,5 kg Mowilith DM-22
0,03 kg Santicizer 160 und
15,0 kg entsalztes Wasser.

Die Lösung wird durch Umkehrwalzenbeschichtung zu einem Beschichtungsgewicht von 4,6 g/m$^2$ auf die lichtempfindliche Schicht aufgebracht.

Der erhaltene Schichtverbund wird einmal zur Übertragung der vollständigen Farbschicht und einmal zur Bildübertragung verwendet.

Beispiel 6

Es wird eine Trennschichtlösung wie in Beispiel 4 hergestellt und durch Umkehrwalzenbeschichtung zu einem Beschichtungsgewicht von 0,87 g/m$^2$ auf eine unbehandelte Polyesterfolie aufgebracht.

Eine blaugrüne Dispersion wird durch Vermahlen der folgenden Komponenten hergestellt:
1,0 kg Phthalocyaninblau (B-115/3),
2,63 kg eines Copolymeren aus Methylmethacrylat und Methacrylsäure (85:15, 30%ige Lösung) und
6,37 kg Butanon.

Einem Teil der blaugrünen Dispersion wird unter mäßigem Rühren das folgende lichtempfindliche Gemisch zugegeben:
2,4 kg der oben beschriebenen blaugrünen Dispersion,
0,8 kg eines Copolymeren aus Methylmethacrylat und Methacrylsäure (85:15, 100 % Feststoff),
0,2 kg eines Copolymeren aus Methylmethacrylat und Methacrylsäure (95: 5, 100 % Feststoff),
1,0 kg Polypropylenglykoldiacrylat,
0,2 kg 2,3-Di-(p-methoxyphenyl)chinoxalin,
7,0 kg Butanon,
7,0 kg 2-Methoxy-ethanol und
1,4 kg Butyrolacton.

Die lichtempfindliche Dispersion wird wie in Beispiel 1 mit einem Dreiwalzen-Umkehrbeschichter auf die trockene Trennschicht aufgebracht und 1 Minute bei 65 °C getrocknet, so daß ein Trockenschichtgewicht von 1,4 g/m$^2$ erhalten wird.

Eine Haftschichtdispersion wird hergestellt, indem die folgenden Komponenten bei Umgebungstemperatur zu einer homogenen Mischung vermischt werden:
15,0 kg Polyvinylacetatemulsion (TS-85; 55%ig und
5,2 kg entsalztes Wasser.

Die Lösung wird zu einem Beschichtungsgewicht von 5,7 g/m$^2$ durch Umkehrwalzenbeschichtung auf die lichtempfindliche Schicht aufgebracht.

Der erhaltene Schichtverbund wird wie in Beispiel 2 einmal zur Übertragung der vollständigen Farbschicht und einmal zur Bildübertragung verwendet.

Beispiel 7

Zur Herstellung einer Trennschicht wird unter mäßigem Rühren eine homogene Lösung hergestellt aus:
1 kg Gelvatol 20/30 und
30 kg entsalztem Wasser.

Diese Lösung wird durch Umkehrwalzenbeschichtung zu einem Beschichtungsgewicht von 0,9 g/m$^2$ auf den unbehandelten Polyesterträger aufgebracht.

Es wird ein lichtempfindliches Gemisch hergestellt, indem die folgenden Komponenten zu einer homogenen Lösung vermischt werden:

1,095 kg eines Copolymeren aus Methylmethacrylat und Methacrylsäure (85:15, 100 % Feststoff),
0,365 kg eines Copolymeren aus Methylmethacrylat und Methacrylsäure (95: 5, 100 % Feststoff),
1,2 kg Tetraethylenglykoldimethacrylat,
0,074 kg Rhodamin 6 GDN,
0,05 kg Rhodamin FB,
0,02 kg Calcozingelb SFW,
0,001 kg Viktoriareinblau FGA,
0,16 kg 9-Phenylacridin,
6,06 kg Butanon und
6,06 kg 2-Methoxy-ethanol.

Die lichtempfindliche Lösung wird mit Hilfe eines Dreiwalzen-Umkehrbeschichters auf die trockene Trennschicht aufgebracht und 1 Minute bei 65 °C getrocknet, so daß sich ein Trockenschichtgewicht von 1 g/m² ergibt.

Dann wird eine Haftschichtlösung wie in Beispiel 3 hergestellt, und durch Umkehrwalzenbeschichtung zu einem Beschichtungsgewicht von 5 g/m² auf die lichtempfindliche Schicht aufgebracht.

Dieser Schichtverbund wird wie in Beispiel 2 sowohl als vollständige Farbschicht als auch als Bild übertragen.

## Patentansprüche

1. Verfahren zur Herstellung eines Mehrfarbenbildes, bei dem man entweder
a) ein lichtempfindliches Material, das auf einem Schichtträger eine Trennschicht, eine photopolymerisierbare Schicht, die ein polymeres Bindemittel, eine polymerisierbare Verbindung mit mindestens zwei Acryl- oder Methacrylsäureestergruppen, einen Initiator, der bei Bestrahlung mit aktinischer Strahlung die radikalische Polymerisation der polymerisierbaren Verbindung einzuleiten vermag, und einen Farbstoff oder ein Farbpigment in einer der Grundfarben des Mehrfarbendrucks enthält, und eine Haftschicht in der angegebenen Reihenfolge trägt, wobei die Trennschicht an dem Schichtträger weniger haftet als an der photopolymerisierbaren Schicht, mit der Haftschicht auf ein Bildempfangsmaterial laminiert, den Schichtträger abzieht, die photopolymerisierbare Schicht bildmäßig unter einem Farbauszug belichtet, die Trennschicht und die unbelichteten Bereiche der photopolymerisierbaren Schicht mit einer Entwicklerlösung zu einem Teilfarbenbild auswäscht und das erhaltene Teilfarbenbild deckungsgleich auf dem Bildempfangsmaterial mit mindestens einem weiteren in gleicher Weise erzeugten Teilfarbenbild einer anderen Grundfarbe vereinigt oder
b) das lichtempfindliche Material belichtet, mit der Haftschicht auf ein Zwischenträgerblatt laminiert, den Schichtträger abzieht, die Trennschicht und die unbelichteten Bereiche der photopolymerisierbaren Schicht auswäscht, das erhaltene Teilfarbenbild zusammen mit der Haftschicht auf ein Bildempfangsmaterial laminiert, das Zwischenträgerblatt abzieht und die vorstehenden Verfahrensschritte mindestens einmal mit einem Material wiederholt, das ein anderes Teilfarbenbild liefert.

2. Verfahren nach Anspruch 1, dadurch gekennzeichnet, daß der Entwickler eine wäßrig-alkalische Lösung ist und das Bindemittel wasserunlöslich und in wäßrig-alkalischen Lösungen löslich ist.

3. Verfahren nach Anspruch 2, dadurch gekennzeichnet, daß die Trennschicht aus einer Substanz besteht, die in wäßrig-alkalischen Lösungen löslich ist.

4. Verfahren nach Anspruch 1, dadurch gekennzeichnet, daß die Haftschicht ein in Wasser dispergierbares Polymeres enthält, das einen Erweichungspunkt im Bereich von 65 bis 82°C hat.

5. Verfahren nach Anspruch 4, dadurch gekennzeichnet, daß die Haftschicht einen Weichmacher enthält.

6. Verfahren nach Anspruch 1, dadurch gekennzeichnet, daß die Haftschicht im Entwickler nicht löslich ist.

## Claims

1. Process for producing a multi-colour image, wherein either
a) a light-sensitive material which carries, on a base, a separating layer, a photopolymerizable layer containing a polymeric binder, a polymerizable compound having at least two acrylic or methacrylic ester groups, and an initiator capable of initiating the free-radical polymerization of the polymerizable compound on exposure to actinic radiation, and a dye or a coloured pigment in one of the primary colours of the multi-colour print, and an adhesion layer in the order indicated, the separation layer adhering less strongly to the base than to the photopolymerizable layer, is laminated by the adhesion layer to an image-receiving material, the base is peeled off, the photopolymerizable layer is exposed imagewise under a colour separation, the separation layer and the unexposed areas of the photopolymerizable layer are washed out with a developer solution to give a progressive colour image and the progressive colour-image obtained is combined congruently on the image-receiving material with at least one further progressive colour image produced in the same way in a different primary colour, or
b) the light-sensitive material is exposed, laminated by the adhesion layer to a temporary support sheet, the base is peeled off, the separation layer and the unexposed areas of the photopolymerizable layer are washed out, the progressive colour image obtained is laminated together with the adhesion layer to an image-receiving material, the temporary support sheet is peeled off and the above process steps are repeated at least once with a material which provides another progressive colour image.

2. Process according to Claim 1, characterized in that the developer is an aqueous-alkaline solution and the binder is water-insoluble and soluble in aqueous-alkaline solutions.

3. Process according to Claim 2, characterized in that the separation layer consists of a substance which is soluble in aqueous-alkaline solutions.

4. Process according to Claim 1, characterized in that the adhesion layer contains a polymer which is dispersible in water and has a softening point in the range from 65 to 82°C.

5. Process according to Claim 4, characterized in that the adhesion layer contains a plasticizer.

6. Process according to Claim 1, characterized in that the adhesion layer is insoluble in the developer.

**Revendications**

1. Procédé pour la production d'une image polychrome, dans lequel soit
a) On applique par laminage, avec la couche adhésive, sur un matériau récepteur d'image un matériau photosensible qui porte, sur un support de couches, une couche de séparation, une couche photopolymérisable qui contient un liant polymère, un composé polymérisable comportant au moins 2 groupes ester d'acide acrylique ou méthacrylique, un initiateur qui permet, lors d'irradiation avec un rayonnement actinique, la polymérisation radicalaire du composé polymérisable, et un colorant ou un pigment coloré en une des couleurs fondamentales de l'impression polychrome, et une couche adhésive, dans l'ordre indiqué, la couche de séparation adhérant moins au support de couches qu'à la couche photopolymérisable, on enlève le support de couches, on expose selon l'image sous une sélection chromatique la couche photopolymérisable, on élimine par lavage avec une solution de développement la couche de séparation et les zones non exposées de la couche photopolymérisable, pour aboutir à une image colorée de sélection, et on réunit, sur le matériau récepteur d'image, de façon à être congruent, l'image colorée de sélection obtenue et au moins une autre image colorée de sélection d'une autre couleur fondamentale, obtenue de la même façon, soit
b) On expose le matériau photosensible, on l'applique par laminage, avec la couche adhésive, sur une feuille de support intermédiaire, on enlève le support de couches, on élimine par lavage la couche de séparation et les zones non exposées de la couche photopolymérisable, on applique par laminage sur un matériau récepteur d'image l'image colorée de sélection obtenue, conjointement avec la couche adhésive, on enlève la feuille de support intermédiaire et on répète au moins une fois les étapes de processus précédentes, avec un matériau qui donne une autre image colorée de sélection.

2. Procédé selon la revendication 1, caractérisé en ce que le révélateur est une solution aqueuse-alcaline et le liant est insoluble dans l'eau et soluble dans des solutions aqueuses-alcalines.

3. Procédé selon la revendication 2, caractérisé en ce que la couche de séparation est constituée d'une substance qui est soluble dans des solutions aqueuses-alcalines.

4. Procédé selon la revendication 1, caractérisé en ce que la couche adhésive contient un polymère dispersable dans l'eau, qui a un point de ramollissement dans la plage de 65 à 82°C.

5. Procédé selon la revendication 4, caractérisé en ce que la couche adhésive contient un plastifiant.

6. Procédé selon la revendication 1, caractérisé en ce que la couche adhésive n'est pas soluble dans le révélateur.